# EUROPEAN PATENT APPLICATION

(11) **EP 4 213 184 A1**
(43) Date of publication of application: **19.07.2023**
(21) Application number: 20959217.9
(22) Date of filing: 30.10.2020
(51) Int. Cl.: H01L 21/335, H01L 29/778, H01L 23/367

(54) **SEMICONDUCTOR DEVICE AND MANUFACTURING METHOD THEREFOR**

(71) Applicant: Huawei Technologies Co., Ltd., Shenzhen, Guangdong 518129 (CN)
(72) Inventor: HU, Bin, Shenzhen, Guangdong 518129 (CN); DUAN, Huantao, Shenzhen, Guangdong 518129 (CN)
(74) Representative: Pfenning, Meinig & Partner mbB
(86) International application number: PCT/CN2020/125328
(87) International publication number: WO 2022/088055

(57) **Abstract**

Embodiments of this application disclose a semiconductor device and a manufacturing method thereof. The semiconductor device may include a substrate, and an epitaxial layer and an electrode that are located on the substrate. The substrate has a diamond structure that longitudinally penetrates the substrate. The diamond structure may be longitudinally divided into a first diamond part and a second diamond part below the first diamond part. The first diamond part and the second diamond part have different lateral dimensions. Due to good thermal conductivity of the diamond partpart, the diamond structure that penetrates the substrate may form a longitudinal heat conduction channel, to improve heat dissipation performance of the semiconductor device. This helps effectively exert high power performance of the semiconductor device. In addition, the first diamond part and the second diamond part have different lateral dimensions, to help control the structure of the first diamond part and the second diamond part. In addition, heat dissipation performance and lattice matching between the epitaxial layer and the substrate are implemented, so that the epitaxial layer with higher quality and the semiconductor device with high performance can be obtained.

## Description

### TECHNICAL FIELD

This application relates to the field of semiconductor manufacturing technologies, and in particular, to a semiconductor device and a manufacturing method thereof.

### BACKGROUND

In a semiconductor device, heat dissipation performance of a substrate is an important factor affecting performance of the device. In some scenarios, high power performance of the semiconductor device cannot be effectively exerted due to limitation of heat dissipation of the substrate.

For example, as the semiconductor device is developing toward high frequency and high power, a gallium nitride (gallium nitride, GaN)-based high-electron-mobility transistor (high-electron-mobility transistor, HEMT) is increasingly applied in a power amplifier (power amplifier, PA) chip in the field of the 5th generation mobile communication technology (the 5th generation mobile network, 5G). As a third generation wide bandgap semiconductor material, gallium nitride has advantages such as high two-dimensional electron gas concentration, a high breakdown voltage, a high electron saturation speed. These advantages provide favorable conditions for a nitride device structure as a high power device, and these new application scenarios also pose higher requirements on power, frequency, efficiency, and reliability of the gallium nitride-based HEMT device. However, heat dissipation has become a key bottleneck for the gallium nitride-based HEMT device. This is because currently a substrate is mostly made of materials such as silicon base and sapphire, and thermal conductivity of these materials is poor. When the gallium nitride device is used as the high power device for outputting, a large amount of heat is generated, and a substrate material with low thermal conductivity cannot dissipate the large amount of heat in time. As a result, performance of a gallium nitride functional device is limited.

### SUMMARY

In view of this, a first aspect of this application provides a semiconductor device and a manufacturing method thereof, to improve heat dissipation performance of the semiconductor device, and effectively exert high power performance of the semiconductor device.

According to a first aspect, an embodiment of this application provides a semiconductor device, including: a substrate, and an epitaxial layer and an electrode that are sequentially located on the substrate. The substrate has a diamond structure that longitudinally penetrates the substrate. The diamond structure is longitudinally divided into a first diamond part and a second diamond part. The second diamond part may be located below the first diamond part. The first diamond part and the second diamond part may have different lateral dimensions. Specifically, the first diamond part and the second diamond part may have completely different or partially different lateral dimensions. Due to good thermal conductivity of the diamond part, the diamond structure that penetrates the substrate may form a longitudinal heat conduction channel, so that heat generated by the operating device may be efficiently conducted to a periphery of the device. Therefore, heat dissipation performance of the semiconductor device is improved, and high power performance of the semiconductor device is effectively exerted. In addition, because the first diamond part and the second diamond part have different lateral dimensions, two etching processes may be used, and a depth-to-width ratio of etching is reduced, to help control the structure of the first diamond part and the second diamond part. In addition, heat dissipation performance and lattice matching between the epitaxial layer and the substrate are implemented, so that the epitaxial layer with higher quality and the semiconductor device with high performance can be obtained.

In some possible implementations, there are a plurality of first diamond parts and a plurality of second diamond parts, the plurality of first diamond parts one-to-one correspond to the plurality of second diamond parts, and the plurality of first diamond parts are of at least one of a conical frustum structure, a square frustum structure, a bowl-shaped structure, a cylindrical structure, and a prism structure.

In this embodiment of this application, the first diamond parts may be in a one-to-one correspondence with the second diamond parts. In this way, one first diamond structure and one second diamond structure may form the longitudinal heat conduction channel, so that a plurality of heat conduction channels may be used to dissipate heat to the periphery of the device. Therefore, high heat dissipation efficiency is implemented. The first diamond part and the second diamond part may have a plurality of shapes, and may be specifically designed for different epitaxial layers. This considers heat dissipation performance and lattice matching, and improves epitaxial quality.

In some possible implementations, a quantity of second diamond parts is less than a quantity of first diamond parts, a plurality of first diamond parts are connected to a same second diamond part, and the first diamond parts are of at least one of a conical frustum structure, a square frustum structure, a bowl-shaped structure, a cylindrical structure, and a prism structure.

In this embodiment of this application, a quantity of second diamond parts that are located below the first diamond part may be less than a quantity of first diamond parts. In this way, one second diamond part may be connected to the plurality of first diamond parts, so that a lateral dimension of the second diamond part may be greater than a lateral dimension of the first diamond part, more diamond parts that are on the substrate and that are far away from the epitaxial layer are exposed, and fewer diamond parts that are on the substrate and that are close to the epitaxial layer are exposed. Therefore, heat dissipation performance of the device is ensured, and epitaxial quality is considered.

In some possible implementations, there is one second diamond part, and the second diamond part is longitudinally connected to all or a part of the first diamond parts.

In this embodiment of this application, there is one second diamond part. In this way, the second diamond part may have a large lateral dimension. This further improves heat dissipation performance of the device without affecting quality of the epitaxial layer.

In some possible implementations, there are a plurality of second diamond parts, the second diamond parts extend in a preset direction parallel to a surface of the substrate, and at least one second diamond part is longitudinally connected to the plurality of first diamond parts.

In this embodiment of this application, there may also be a plurality of second diamond parts, and the plurality of second diamond parts may extend in a same direction. In this way, the second diamond part may have a large lateral dimension. This further improves heat dissipation performance of the device without affecting quality of the epitaxial layer.

In some possible implementations, a lateral dimension of the first diamond part ranges from 1 to 10 µm, a longitudinal dimension of the first diamond part ranges from 1 to 10 µm, a spacing between different first diamond parts ranges from 1 to 10 µm, and a thickness of the substrate ranges from 50 to 100 µm.

In this embodiment of this application, the first diamond part may occupy a small part of the thickness of the substrate, and the first diamond parts are properly spaced. This ensures heat dissipation performance of the device while ensuring quality of the epitaxial layer.

In some possible implementations, a material of the substrate is one or more of silicon, silicon carbide, aluminum nitride, or sapphire.

In this embodiment of this application, the substrate may be one or more of a silicon substrate, a silicon carbide substrate, an aluminum nitride substrate, or a sapphire substrate. Even if heat dissipation performance of the substrate is not good enough, after a heat dissipation channel is formed by using a diamond, heat dissipation performance of the device is ensured, a manufacturing process of the substrate is simple, and it is easy to produce the substrate on a large scale.

In some possible implementations, the diamond structure is a monocrystalline diamond or a polycrystalline diamond.

In this embodiment of this application, the diamond structure may be the monocrystalline diamond or the polycrystalline diamond, and whether the diamond structure is the monocrystalline diamond or the polycrystalline diamond may be determined based on an actual situation, provided that good heat dissipation can be implemented.

In some possible implementations, the epitaxial layer includes a buffer layer and a barrier layer, the buffer layer is a gallium nitride layer, and a material of the barrier layer is one or more of AlGaN, InAlN, AlN, and ScAlN.

In this embodiment of this application, the epitaxial layer may include the buffer layer and the barrier layer, and the buffer layer may be the gallium nitride layer. Therefore, the semiconductor structure may be a gallium nitride device, and two-dimensional electron gas may be formed between the barrier layer and the gallium nitride layer, to provide better device performance.

In some possible implementations, a thickness of the gallium nitride layer ranges from 0.1 to 2 µm, and a thickness of the barrier layer ranges from 5 to 20 nm.

In this embodiment of this application, thicknesses of the gallium nitride layer and the barrier layer may be within a proper range, to ensure device performance.

In some possible implementations, the electrode includes a source electrode, a drain electrode, and a gate electrode, and a material of the electrode is at least one of Au, Ti, Al, Ni, and Ta.

In this embodiment of this application, the electrode may include the source electrode, the drain electrode, and the gate electrode, and there may be a plurality of electrode materials, to ensure integrity and a high performance of the device.

A second aspect of embodiments of this application provides a method for manufacturing a semiconductor device, including:
providing a substrate;
etching a first surface of the substrate to obtain a first groove;
filling the first groove with a diamond material;
sequentially forming an epitaxial layer and an electrode on the first surface of the substrate;
etching a second surface of the substrate to obtain a second groove, where the second groove is connected to the first groove, where the second groove and the first groove have different lateral dimensions, and the first surface and the second surface are two opposite surfaces; and
filling the second groove with a diamond material.

In this embodiment of this application, the diamond material on the first surface of the substrate may be first formed, a device structure on the substrate may be formed, and then a diamond structure of the second surface may be formed. This matches a conventional-technology step of turning over the device to perform bonding after the device structure is formed. Therefore, the high performance and high dissipation device in this embodiment of this application can be obtained with as few steps as possible.

In some possible implementations, there are a plurality of first grooves and a plurality of second grooves, the plurality of first grooves one-to-one correspond to the plurality of second grooves, and a shape of diamond materials in the first grooves and the second groove is at least one of a conical frustum structure, a square frustum structure, a bowl-shaped structure, a cylindrical structure, and a prism structure.

In some possible implementations, a quantity of second grooves is less than a quantity of first grooves, a plurality of first grooves are connected to a same second groove, and a shape of the first grooves is one of a conical frustum structure, a square frustum structure, a bowl-shaped structure, a cylindrical structure, and a prism structure.

In some possible implementations, there is one second groove, and all or a part of the diamond material in the first groove is exposed at the bottom of the second groove.

In some possible implementations, the second grooves are a plurality of grooves that extend in a preset direction parallel to a surface of the substrate, and diamond materials in the plurality of first grooves are exposed at the bottom of at least one second groove.

In some possible implementations, before the etching a second surface of the substrate to obtain a second groove, the method further includes:
thinning the substrate from the second surface of the substrate.

A third aspect of embodiments of this application provides a method for manufacturing a semiconductor device, including:
providing a substrate;
etching a first surface of the substrate to obtain a first groove, and filling the first groove with a diamond material; and etching a second surface of the substrate to obtain a second groove, and filling the second groove with a diamond material, where the second groove and the first groove are connected and have different lateral dimensions, and the first surface and the second surface are two opposite surfaces; and
sequentially forming an epitaxial layer and an electrode on the first surface of the substrate.

In this embodiment of this application, the diamond material on the first surface of the substrate may be first formed, then a diamond structure on the second surface may be formed, and then a device structure on the substrate may be formed. In this way, a complete substrate can be obtained before the device structure is formed, and the device structure may be formed on the first surface, or may be formed on the second surface. Therefore, different requirements can be met.

In some possible implementations, there are a plurality of first grooves and a plurality of second grooves, the plurality of first grooves one-to-one correspond to the plurality of second grooves, and a shape of diamond materials in the first grooves and the second groove is at least one of a conical frustum structure, a square frustum structure, a bowl-shaped structure, a cylindrical structure, and a prism structure.

In some possible implementations, a quantity of second grooves is less than a quantity of first grooves, a plurality of first grooves are connected to a same second groove, and the first grooves are at least one of a conical frustum structure, a square frustum structure, a bowl-shaped structure, a cylindrical structure, and a prism structure.

In some possible implementations, there is one second groove; if the second groove is formed after the first groove, all or a part of diamond materials in the first grooves are exposed at the bottom of the second groove; and if the second groove is formed before the first groove, the diamond material in the second groove is exposed at the bottoms of the plurality of first grooves.

In some possible implementations, the second grooves are a plurality of grooves that extend in a preset direction parallel to a surface of the substrate; if the second groove is formed after the first groove, diamond materials in the plurality of first grooves are exposed at the bottom of at least one second groove; and if the second groove is formed before the first groove, the diamond material in the same second groove is exposed at the bottoms of the plurality of first grooves.

In some possible implementations, before the etching a second surface of the substrate to obtain a second groove, the method further includes:
thinning the substrate from the second surface of the substrate.

A fourth aspect of embodiments of this application provides a power amplifier chip, including the semiconductor device provided in the first aspect of embodiments of this application.

According to the foregoing technical solutions, it can be learned that embodiments of this application have the following advantages.

Embodiments of this application provide the semiconductor device and the manufacturing method thereof. The semiconductor device may include the substrate, and the epitaxial layer and the electrode that are located on the substrate. Te substrate has the diamond structure that longitudinally penetrates the substrate. The diamond structure may be longitudinally divided into the first diamond part and the second diamond part below the first diamond part. The first diamond part and the second diamond part have different lateral dimensions. Due to good thermal conductivity of the diamond part, the diamond structure that penetrates the substrate may form the longitudinal heat conduction channel. Therefore, heat generated by the operating device may be efficiently conducted to the periphery of the device. Therefore, heat dissipation performance of the semiconductor device is improved, and high power performance of the semiconductor device is effectively exerted. In addition, because the first diamond part and the second diamond part have different lateral dimensions, two etching processes may be used, and a depth-to-width ratio of etching is reduced, to help control the structure of the first diamond part and the second diamond part. In addition, heat dissipation performance and lattice matching between the epitaxial layer and the substrate are implemented, so that the epitaxial layer with higher quality and the semiconductor device with high performance can be obtained. At the same time, a manufacturing process of the semiconductor device is not complex, and the substrate is easy to produce on a large scale.

### BRIEF DESCRIPTION OF DRAWINGS

To clearly understand specific implementations of this application, the following briefly describes accompanying drawings used for describing the specific implementations of this application, and is clear that the accompanying drawings show merely some embodiments of this application.
FIG. 1 is a schematic diagram of a base station according to an embodiment of this application;
FIG. 2A is a schematic diagram of a structure of a semiconductor device according to an embodiment of this application;
FIG. 2B is a schematic diagram of a structure of another semiconductor device according to an embodiment of this application;
FIG. 3 is a schematic diagram of a structure of still another semiconductor device according to an embodiment of this application;
FIG. 4 is a flowchart of a semiconductor device manufacturing method according to an embodiment of this application;
FIG. 5 to FIG. 12 are schematic diagrams of structures of components in a semiconductor device manufacturing method according to an embodiment of this application; and
FIG. 13 is a flowchart of another semiconductor device manufacturing method according to an embodiment of this application.

### DESCRIPTION OF EMBODIMENTS

Embodiments of this application provide a semiconductor device and a manufacturing method thereof, to improve heat dissipation performance of the semiconductor device, and effectively exert high power performance of the semiconductor device.

In the specification, claims, and accompanying drawings of this application, the terms "first", "second", "third", "fourth", and the like (if existent) are intended to distinguish between similar objects but do not necessarily indicate a specific order or sequence. It should be understood that the data termed in such a way are interchangeable in proper circumstances so that embodiments of this application described herein can be implemented in other orders than the order illustrated or described herein. In addition, the terms "include" and "have" and any variants thereof are intended to cover non-exclusive inclusion. For example, a process, method, system, product, or device that includes a list of steps or units is not necessarily limited to those expressly listed steps or units, but may include other steps or units not expressly listed or inherent to such a process, method, product, or device.

This application describes in detail with reference to schematic diagrams. When embodiments of this application are described in detail, for ease of description, a cross-sectional diagram indicating a component structure is not partially enlarged according to a general scale. In addition, the schematic diagrams are merely examples, and shall not limit the protection scope of this application herein. In addition, three-dimensional space dimensions of a length, a width and a depth should be included in an actual production.

In the semiconductor device, heat dissipation performance of a substrate is an important factor affecting performance of the device. In some scenarios, the high power performance of the semiconductor device cannot be effectively exerted due to a limitation of heat dissipation of the substrate.

For example, as a third generation wide bandgap semiconductor material, gallium nitride has advantages such as high two-dimensional electron gas concentration, a high breakdown voltage, a high electron saturation speed. These advantages provide favorable conditions for a nitride device structure as a high power device. However, due to the limitation of heat dissipation of the substrate, the high power performance of the semiconductor device cannot be effectively exerted. This is because currently a substrate is mostly made of materials such as silicon and sapphire, and thermal conductivity of these materials is poor. When the semiconductor device is used as the high power device for outputting, a large amount of heat is generated, and a substrate material with low thermal conductivity cannot dissipate the large amount of heat in time. As a result, performance of a semiconductor functional device is limited. Generally, thermal conductivity of the sapphire material is 30 to 40 W/mk, thermal conductivity of a silicon substrate material is 130 to 150 W/mk, and thermal conductivity of a silicon carbide (silicon carbide, SiC) substrate whose structure type of single crystal is 4H (which is denoted as a 4H-SiC substrate) ranges from 280 to 370 W/mk. Even though thermal conductivity of a silicon carbide substrate is several times that of a conventional silicon or sapphire substrate, the silicon carbide substrate still fails to meet a heat dissipation requirement of the gallium nitride high power electronic device. Therefore, the high power performance of the gallium nitride high power device is limited to a certain extent.

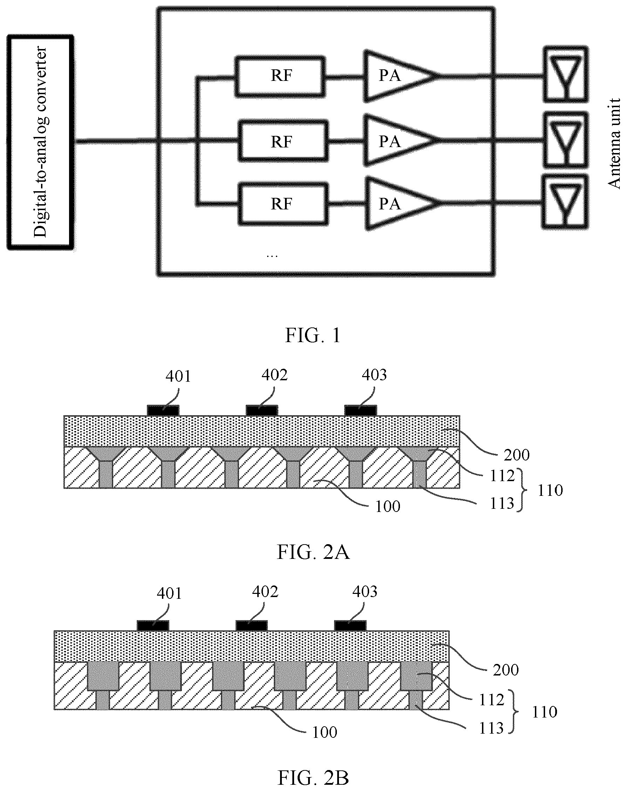

As the semiconductor device is developing toward a trend of a high frequency and high power, a gallium nitride-based HEMT device is increasingly applied on a PA chip in the 5G field. The following describes an application scenario of a PA. FIG. 1 is a schematic diagram of a base station according to an embodiment of this application. An active antenna unit (active antenna unit, AAU) of the base station may include a digital-to-analog converter (digital-to-analog converter, DAC), a radio frequency (radio frequency, RF) unit, a power amplifier (PA), an antenna, and the like. The digital-to-analog converter converts main digital information in the AAU into an analog signal. Then, the radio frequency unit modulates the analog signal into a high frequency signal. Finally, the power amplifier amplifies the high frequency signal to sufficient power, and then, the antenna unit transmits an amplified signal. The PA is a major power consumption unit in overall power consumption of the base station. In addition, for a 5G base station, a large quantity of energy is consumed in a form of heat in power consumption of a PA in an AAU. Therefore, the PA needs to have a better heat dissipation capability to ensure safety of a radio frequency PA chip. If the large amount of heat cannot be conducted out of the device in time, the PA is fatally affected, reliability of the PA is reduced, and even the PA may be damaged. For example, radio frequency output power of the antenna is 100 W. If power consumption efficiency of the PA is 50%, the PA needs to consume 200 W of energy, and 100 W of energy needs to be consumed in the form of heat. If the power consumption efficiency of the PA is 30%, the PA needs to consume 333 W of energy, and 233 W of energy needs to be consumed in the form of heat. This imposes extremely high requirements on the heat dissipation of the device.

A solution to resolve a heat dissipation problem of a high power device is to find a material with good thermal conductivity as a substrate of the high power device, and then directly grow an epitaxial layer material on the material, or effectively bond the epitaxial layer material with the material of the substrate. In this way, good heat dissipation is implemented. It is found that a diamond has good thermal conductivity (500 W/mk to 2000 W/mk), and the heat dissipation problem can be effectively resolved by using the diamond as a substrate of a semiconductor high power device. For example, the diamond is used as a substrate of the HEMT device, and the device has currently achieved good performance of over 10 W/mm output power at 10 GHz.

However, there are still a series of challenges when the diamond is used as a device substrate. For example, if the epitaxial layer material is directly grown on a diamond substrate, epitaxial growth is difficult. As a result, film formation of the epitaxial layer material is affected, and electrical performance of the device is poor. Moreover, the diamond substrate is generally small, and it is difficult to realize large-scale industrial mass production. If the diamond substrate is bonded on a back side of the semiconductor device, an interface bonding material with low thermal conductivity is needed. This reduces overall heat dissipation performance of the device, and consequently, a performance advantage of the device cannot be fully utilized.

Based on the foregoing technical problem, embodiments of this application provide a semiconductor device and a manufacturing method thereof. The semiconductor device may include a substrate, and an epitaxial layer and an electrode that are located on the substrate. The substrate has a diamond structure that longitudinally penetrates the substrate. The diamond structure includes a first diamond part and a second diamond part below the first diamond part. The first diamond part and the second diamond part have different lateral dimensions. Due to good thermal conductivity of the diamond part, the diamond structure that penetrates the substrate may form the longitudinal heat conduction channel, so that heat generated by the operating device may be efficiently conducted to a periphery of the device. Therefore, heat dissipation performance of the semiconductor device is improved, and high power performance of the semiconductor device is effectively exerted. In addition, because the first diamond part and the second diamond part have different lateral dimensions, two etching processes may be used, and a depth-to-width ratio of etching is reduced, to help control the structure of the first diamond part and the second diamond part. In addition, heat dissipation performance and lattice matching between the epitaxial layer and the substrate are implemented, so that the epitaxial layer with higher quality and the semiconductor device with high performance can be obtained. At the same time, a manufacturing process of the semiconductor device is not complex, and the substrate is easy to produce on a large scale.

To make the objectives, features, and advantages of this application more apparent and understandable, the following describes specific implementations of this application in detail with reference to the accompanying drawings.

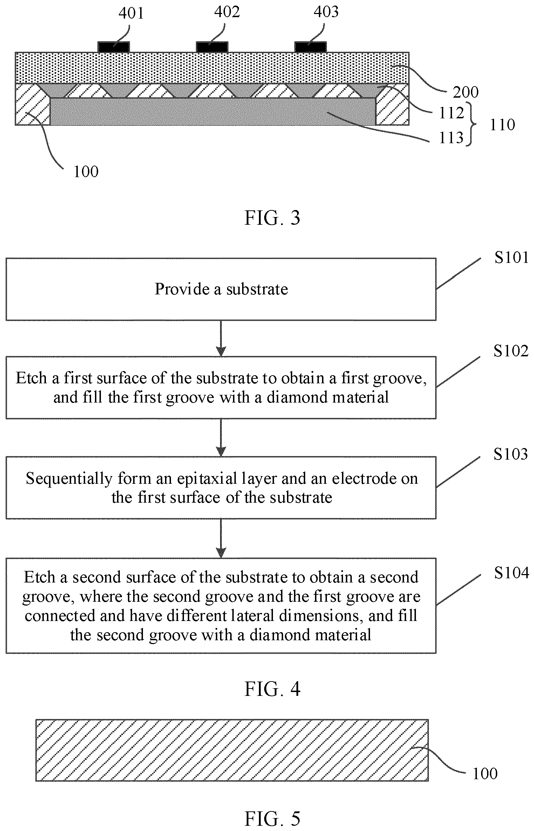

FIG. 2A, FIG. 2B, and FIG. 3 are schematic diagrams of a structure of a semiconductor device according to an embodiment of this application. The semiconductor device may include a substrate 100, an epitaxial layer 200, and electrodes 401, 402, and 403 from bottom to top.

In this embodiment of this application, the substrate 100 is a component that provides support for the device, has certain thermal conductivity, and can dissipate heat generated when the device works to the outside. The substrate 100 may be a semi-insulating semiconductor material. Specifically, a material of the substrate 100 may be one or more of silicon, silicon carbide, aluminum nitride, and sapphire. The following describes an example in which the material of the substrate 100 is silicon carbide, to be specific, 4H-SiC single crystal. Thermal conductivity of a 4H-SiC single substrate material generally ranges from 280 to 370 W/mk. This limits high power performance of the semiconductor device.

In this embodiment of this application, the substrate 100 may have a diamond structure 110 that longitudinally penetrates the substrate, and the diamond structure 110 is a monocrystalline diamond or a polycrystalline diamond. Due to good thermal conductivity of a diamond (500 to 2000 W/mk), the diamond structure 110 that longitudinally penetrates the substrate 100 may form a longitudinal heat dissipation channel. This greatly improves heat dissipation efficiency of the device.

The diamond structure 110 may be longitudinally divided into a first diamond part 112 and a second diamond part 113. The second diamond part 113 is located below the first diamond part 112. The first diamond part 112 and the second diamond part 113 have different lateral dimensions. For example, a lateral dimension of the first diamond part 112 is greater than a lateral dimension of the second diamond part 113, or the lateral dimension of the first diamond part 112 is smaller than the lateral dimension of the second diamond part 113. Alternatively, the first diamond part 112 and the second diamond part 113 have different structures. Therefore, the first diamond part 112 and the second diamond part 113 have different dimensional characteristics. A lateral direction refers to a direction along a surface of the substrate, and a longitudinal direction refers to a direction perpendicular to the surface of the substrate, and is also a direction in which the substrate 100 and the epitaxial layer 200 are stacked. In FIG. 2A, FIG. 2B, and FIG. 3, the lateral direction may be a horizontal direction and a direction perpendicular to the paper in the figure, and the longitudinal direction may be a vertical direction in the figure. The first diamond part 112 may have a same lateral dimension or different lateral dimensions at different heights, and the second diamond part 113 may have a same lateral dimension or different lateral dimensions at different heights. The first diamond part 112 and the second diamond part 113 are connected in the longitudinal direction, and contact positions may have a same lateral dimension or different lateral dimensions.

In this embodiment of this application, that the first diamond part 112 and the second diamond part 113 have different lateral dimensions may include: The first diamond part 112 and the second diamond part 113 may have completely different or not completely different lateral dimensions. Specifically, there may be a plurality of cases when the first diamond part 112 and the second diamond part 113 are completely different or not completely different. In a first case, if the first diamond part 112 has a same lateral dimension at different heights, the second diamond part 113 has a same lateral dimension at different heights, and the first diamond part 112 and the second diamond part 113 have different lateral dimensions, the first diamond part 112 and the second diamond part have completely different lateral dimensions. In a second case, if one of the first diamond part 112 and the second diamond part 113 has a same lateral dimension at different heights, and the other one has different lateral dimensions at different heights, the first diamond part 112 and the second diamond part 113 have completely different or not completely different lateral dimensions. In a third case, if the first diamond part 112 has different lateral dimensions at different heights, and the second diamond part 113 has different lateral dimensions at different heights, the first diamond part 112 and the second diamond part 113 have completely different or not completely different lateral dimensions. For example, if the first diamond part 112 and the second diamond part 113 may have different shapes, or may have a same shape, the first diamond part 112 and the second diamond part 113 have partially different or completely different lateral dimensions.

Because the diamond structure 110 longitudinally penetrates the substrate 100, a sum of longitudinal dimensions of the first diamond part 112 and the second diamond part 113 is the same as a thickness of the substrate 100. In this embodiment of this application, the thickness of the substrate 100 may range from 50 to 100 µm, and the longitudinal dimensions of the first diamond part 112 and the second diamond part 113 may be determined based on shapes of the first diamond part 112 and the second diamond part 113.

Specifically, there may be a plurality of first diamond parts 112 and a plurality of second diamond parts 113, and the plurality of first diamond parts 112 one-to-one correspond to the plurality of second diamond parts 113. In other words, one first diamond part 112 may be connected to one second diamond part 113, to form the diamond structure 110 that penetrates the substrate 100. The shapes of the first diamond part 112 and the second diamond part 113 may be at least one of a conical frustum structure, a square frustum structure, a bowl-shaped structure, a cylindrical structure, and a prism structure. To be specific, the shapes of the first diamond part 112 and the second diamond part 113 may be the same or different. When the first diamond part 112 is of the conical frustum structure, the square frustum structure, or the bowl-shaped structure, the first diamond part 112 may have different lateral dimensions at different heights, and one end with a larger lateral dimension is generally located in a direction of the surface of the substrate 10. When the second diamond part 113 is of the conical frustum structure, the square frustum structure, or the bowl-shaped structure, the second diamond part 113 may have different lateral dimensions at different heights, and one end with a larger lateral dimension is generally located in the direction of the surface of the substrate 10. When the first diamond part 112 is of the conical frustum structure, the square frustum structure, or the bowl-shaped structure, an included angle between a side wall of the first diamond part 112 and the surface of the substrate is 10 to 80 degrees, and specifically, may be 30 to 60 degrees. An included angle between a side wall of the bowl-shaped structure and the surface of the substrate 100 may be defined as an included angle between the surface of the substrate and a line connecting a center point of a bottom of the bowl-shaped structure and an upper edge of the bowl-shaped structure. The second diamond part 113 has similar characteristics.

As shown in FIG. 2A, the first diamond part 112 may be of the conical frustum structure, and the second diamond part 113 may be of the cylindrical structure. Certainly, the first diamond part 112 and the second diamond part 113 may be of cylindrical structures with different diameters (as shown in FIG. 2B, a diameter of the first diamond part 112 may be larger than a diameter of the second diamond part 113) or may be of other structures. A longitudinal dimension of the first diamond part 112 may be 1 to 10 µm, a lateral dimension of the first diamond part 112 may range from 1 to 10 µm, a spacing between the first diamond parts 112 may range from 1 to 10 µm, and a lateral dimension of the second diamond part 113 may range from 5 to 20 µm. When the first diamond part 112 has different lateral dimensions at different heights, the foregoing dimensions represent dimensions of the first diamond part 112 at the surface of the substrate. When the second diamond part 113 has different lateral dimensions at different heights, the foregoing dimensions represent dimensions of the second diamond part 113 at the surface of the substrate. When the first diamond part 112 is presented as a circle on the surface of the substrate, a dimension of the first diamond part 112 is a diameter of the first diamond part 112. When the first diamond part 112 is presented as a polygon on the surface of the substrate, the dimension of the first diamond part 112 is a side length of the first diamond part 112. The second diamond part 113 has similar characteristics.

Specifically, the first diamond part 112 may not be in a one-to-one correspondence with the second diamond part 113, and a quantity of the second diamond parts 113 may be less than a quantity of the first diamond parts 112. In this way, a plurality of first diamond parts 112 are connected to a same second diamond part 113, and a shape of the first diamond parts 112 may be at least one of a conical frustum structure, a square frustum structure, a bowl-shaped structure, a cylindrical structure, and a prism structure, and shapes of all the first diamond parts 112 may be consistent or may not be consistent. Refer to FIG. 3. The second diamond part 113 may be of an integral structure, and the second diamond part 113 may be longitudinally connected to each of the first diamond parts 112, or may be longitudinally connected to only a part of the first diamond parts 112, or there may be a plurality of second diamond parts 113. In addition, the second diamond part 113 extends in a preset direction parallel to the surface of the substrate, and at least one second diamond part 113 is longitudinally connected to the plurality of first diamond parts 112, to form a through structure from bottom to top.

The epitaxial layer 200 may be formed on the substrate 100. In a GaN-based HEMT device, the epitaxial layer 200 may include a buffer layer and a barrier layer. The buffer layer and the barrier layer may form a heterostructure to generate two-dimensional electron gas, and a formed semiconductor device may work by using the two-dimensional electron gas generated by the heterostructure. Certainly, the semiconductor device in this embodiment of this application may also be another energy source device or a laser, and when the semiconductor device is the another energy source device or the laser, the epitaxial layer is an epitaxial layer in the another device. Examples are not enumerated herein. The buffer layer may be a gallium nitride layer, and a material of the barrier layer may be at least one of AlGaN, InAlN, AlN, and ScAlN. A thickness of the buffer layer may range from 0.1 to 2 µm, and a thickness of the barrier layer may range from 5 to 20 nm. Because the substrate 100 is a silicon carbide substrate, a part of a diamond structure is exposed on the surface of the substrate, and a lattice matching degree between the gallium nitride layer and the substrate 100 is high, the gallium nitride layer has good epitaxial quality. This helps form a high performance device. The gallium nitride layer may include a low-temperature gallium nitride layer and a high-temperature gallium nitride layer, and the low-temperature gallium nitride layer serves as the buffer layer between the high-temperature gallium nitride layer and the substrate, to improve epitaxial quality of the high-temperature gallium nitride layer.

The electrodes 401, 402, and 403 may be formed on the epitaxial layer 200. The electrode may include the source electrode 401, the drain electrode 403, and the gate electrode 402. The gate electrode 402 may be located between the source electrode 401 and the drain electrode 403. A material of the electrodes 401, 402, and 403 may be a metal material, for example, may be at least one of Au, Ti, Al, Ni, and Ta. In a possible implementation, the material of the electrodes may be Au, Ti/Al/Ni/Au stack, or Ta/Al/Ta stack.

An embodiment of this application provides a semiconductor device. The semiconductor device may include a substrate, and an epitaxial layer and an electrode that are located on the substrate. The substrate has a diamond structure that longitudinally penetrates the substrate. The diamond structure includes a first diamond part and a second diamond part below the first diamond part. The first diamond part and the second diamond part have different lateral dimensions. Due to good thermal conductivity of the diamond part, the diamond structure that penetrates the substrate may form a longitudinal heat conduction channel, so that heat generated by the operating device may be efficiently conducted to a periphery of the device. Therefore, heat dissipation performance of the semiconductor device is improved, and high power performance of the semiconductor device is effectively exerted. In addition, because the first diamond part and the second diamond part have different lateral dimensions, two etching processes may be used, and a depth-to-width ratio of etching is reduced, to help control the structure of the first diamond part and the second diamond part. In addition, heat dissipation performance and lattice matching between the epitaxial layer and the substrate are implemented, so that the epitaxial layer with higher quality and the semiconductor device with high performance can be obtained. At the same time, a manufacturing process of the semiconductor device is not complex, and the substrate is easy to produce on a large scale.

Based on the semiconductor device provided in the foregoing embodiments, an embodiment of this application further provides a semiconductor device manufacturing method. FIG. 4 is a flowchart of a semiconductor device manufacturing method that provides a substrate 100 according to an embodiment of this application. FIG. 5 to FIG. 12 are schematic diagrams of structures of components in a device manufacturing process. In this method, a first diamond part 112 in a diamond structure may be first formed in the substrate 100, then a device structure on the substrate 100 may be formed, and a second diamond part 113 in the diamond structure may be formed in the substrate 100. Specifically, the method may include the following steps.

S101: Provide the substrate 100, as shown in FIG. 5.

In this embodiment of this application, the substrate 100 is a component that provides support for the device, has certain thermal conductivity, and can dissipate heat generated by the operating device to the outside. The substrate 100 may be a semi-insulating semiconductor material. Specifically, a material of the substrate 100 may be one or more of silicon, silicon carbide, aluminum nitride, and sapphire. The following describes an example in which the material of the substrate 100 is silicon carbide, to be specific, 4H-SiC single crystal. Thermal conductivity of a 4H-SiC single substrate material generally ranges from 280 to 370 W/mk. This limits high power performance of the semiconductor device.

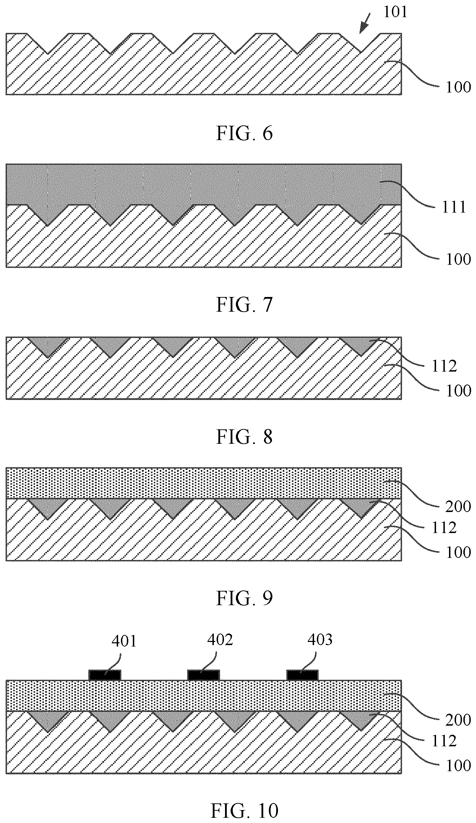

S102: Etch a first surface of the substrate 100 to obtain a first groove 101, and fill the first groove 101 with a diamond material, as shown in FIG. 6 to FIG. 8.

In this embodiment of this application, the first surface of the substrate 100 may be etched to obtain the first groove 101. Refer to FIG. 6. The first groove 101 is filled with the diamond material, and the diamond material filled in the first groove 101 may be used as the first diamond part 112 in the foregoing embodiments, as shown in FIG. 8. The substrate 100 may be etched through dry anisotropic etching, such as plasma etching. A lateral dimension of the first groove 101 obtained through etching is 1 to 10 µm, an etching depth is 1 to 10 µm, a spacing between different first grooves 101 ranges from 1 to 10 µm, and the first grooves 101 may be arranged in a periodic array.

A shape of the first groove 101 may be controlled by controlling an etching parameter of the substrate 100. The shape of the first groove 101 may be at least one of a conical frustum structure, a square frustum structure, a bowl-shaped structure, a cylindrical structure, and a prism structure. One end with a larger dimension of the conical frustum structure, the square frustum structure, and the bowl-shaped structure faces a surface of the substrate. In an etching process, an etching rate may be slowed down, to reduce damage caused by etching gas to a side wall of the first groove 101. In this way, the first groove 101 with a structure that is larger on an upper part and small on a lower part is formed.

After the first groove 101 is formed through etching, the first groove 101 may be filled with the diamond material, and the diamond material is a monocrystalline diamond or a polycrystalline diamond. Specifically, the diamond material may be grown on the substrate 100 on which the first groove 101 is formed. After a period of growth, a high-quality polycrystalline diamond layer 111 with a thickness of 1 to 50 µm may be generated on the substrate, as shown in FIG. 7. Then, a part of the diamond layer 111 is removed through grinding and polishing, to expose the surface of the substrate 100. In this way, the diamond material is filled in the first groove 101, and a dimension of the diamond material is consistent with or approximate to a dimension of the first groove 101, as shown in FIG. 8. The diamond material can be grown in a microwave plasma chemical vapor deposition (microwave plasma chemical vapor deposition, MPCVD) manner, and a temperature at which the diamond material is grown may be 800 to 1200 °C, and a pressure at which the diamond material is grown may range from 1 to 15 kPa. The MPCVD method has advantages such as stable plasma discharge and less pollution, so that a diamond material with high quality can be grown.

S103: Sequentially form an epitaxial layer 200 and electrodes 401, 402, and 403 on the first surface of the substrate 100, as shown in FIG. 9 to FIG. 10.

The epitaxial layer 200 may be formed on the first surface of the substrate 100. Refer to FIG. 9. When the semiconductor device is a GaN-based HEMT device, the epitaxial layer 200 may include a buffer layer and a barrier layer. The buffer layer and the barrier layer may form a heterostructure, to generate two-dimensional electron gas, and a formed semiconductor device may work by using the two-dimensional electron gas generated by the heterostructure. The buffer layer may be a gallium nitride layer, and a material of the barrier layer may be at least one of AlGaN, InAlN, AlN, and ScAlN. A thickness of the buffer layer may range from 0.1 to 2 µm, and a thickness of the barrier layer may range from 5 to 20 nm.

Specifically, the buffer layer may be formed on the first surface of the substrate 100, and then the barrier layer may be formed on the buffer layer. The gallium nitride layer may be formed through metal organic chemical vapor deposition (Metal organic chemical vapor deposition, MOCVD). Because a lattice mismatch between the diamond material and the gallium nitride is severe, the gallium nitride grows quickly on the silicon carbide, and grows slowly or even cannot grow on the diamond material. In this way, lateral growth of gallium nitride on the silicon carbide is strengthened, and dislocations are combined. Therefore, the gallium nitride layer with higher quality is obtained. When the diamond material formed in the first groove is of the conical frustum structure, the square frustum structure, or the bowl-shaped structure, it is more conducive for growth of gallium nitride on the substrate. Therefore, the gallium nitride layer with higher quality is obtained. The gallium nitride layer may include a low-temperature gallium nitride layer and a high-temperature gallium nitride layer, and the low-temperature gallium nitride layer serves as the buffer layer between the high-temperature gallium nitride layer and the substrate, to improve epitaxial quality of the high-temperature gallium nitride layer. The barrier layer may also be formed in the MOCVD manner.

The electrodes 401, 402, and 403 may be formed on the epitaxial layer 200. The electrodes 401, 402, and 403 may include the source electrode 401, the drain electrode 403, and the gate electrode 402. The gate electrode 402 may be located between the source electrode 401 and the drain electrode 403, as shown in FIG. 10. A material of the electrodes 401, 402, and 403 may be a metal material, for example, may be at least one of Au, Ti, Al, Ni, and Ta. In a possible implementation, the material of the electrodes 401, 402, and 403 may be Au, Ti/Al/Ni/Au stack, or Ta/Al/Ta stack.

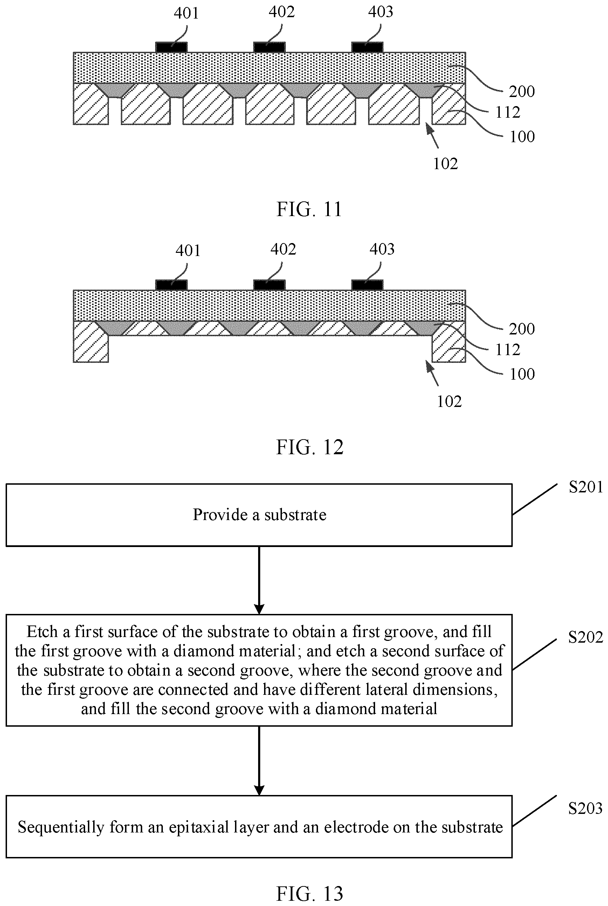

S104: Etch a second surface of the substrate 100 to obtain a second groove 102, where the second groove 102 is connected to the first groove 101, and the first groove 101 and the second groove 102 have different lateral dimensions, and fill the second groove 102 with a diamond material. Refer to FIG. 11, FIG. 12, FIG. 2A, FIG. 2B, and FIG. 3.

After the electrodes 401, 402, and 403 are formed, a dielectric layer may be formed to cover the electrodes 401, 402, and 403, to protect the electrodes (not shown in the figure). Then, the second surface of the substrate 100 may be etched to obtain the second groove 102, where the first surface and the second surface are two opposite surfaces, as shown in FIG. 11 and FIG. 12. In addition, the second groove 102 is filled with the diamond material, and the diamond material in the second groove 102 may be used as the second diamond part 113 in the foregoing embodiment. As shown in FIG. 2A, 2B, and 3, the first groove 101 is connected to the second groove 102, so that the diamond material in the first groove 101 and the diamond material in the second groove 102 are in contact, to form the diamond structure 110 that penetrates the substrate. Because the first groove 101 and the second groove 102 have different lateral dimensions, diamond structures that are separately formed by the first groove 101 and the second groove 102, that is, the first diamond part 112 and the second diamond part 113, have different lateral dimensions. Due to good thermal conductivity of a diamond, the diamond structure that longitudinally penetrates the substrate may form a longitudinal heat dissipation channel. This greatly improves heat dissipation efficiency of the device. Before the second surface of the substrate 100 is etched, the substrate 100 may be further thinned from the second surface of the substrate 100, so that a thickness of the substrate 100 ranges from 50 to 100 µm, and a sum of longitudinal dimensions of the first diamond part 112 and the second diamond part 113 is the same as a thickness of the substrate 100.

In an actual operation, after the device is formed, a chip may be bonded, and at this time, the chip is turned over, so that a substrate of the chip faces upward to implement bonding, and the foregoing step of etching the second surface of the substrate is compatible with steps in an actual operation. Therefore, a higher performance device can be obtained without adding too many steps.

Specifically, there may be a plurality of first grooves 101 and a plurality of second grooves 102, the first grooves 101 may be in a one-to-one correspondence with the second grooves 102, and one first groove 101 may be connected to one second groove 102, to form a through hole that penetrates the substrate, as shown in FIG. 11. Shapes of the first groove 101 and the second groove 102 may be at least one of the conical frustum structure, the square frustum structure, the bowl-shaped structure, the cylindrical structure, and the prism structure. The shapes of the first groove 101 and the second groove 102 may be the same or different. When the first diamond part 112 is of the conical frustum structure, the square frustum structure, or the bowl-shaped structure, one end with a larger lateral dimension is generally located in a direction of the surface of the substrate. When the second diamond part 113 is of the conical frustum structure, the square frustum structure, or the bowl-shaped structure, one end with a larger lateral dimension is generally located in the direction of the surface of the substrate. When the first groove 101 is of the conical frustum structure, the square frustum structure, or the bowl-shaped structure, an included angle between a side wall of the first groove 101 and the surface of the substrate is 10 to 80 degrees, and specifically, may be 30 to 60 degrees. An included angle between a side wall of the bowl-shaped structure and the surface of the substrate may be defined as an included angle between the surface of the substrate and a line connecting a center point of a bottom of the bowl-shaped structure and an upper edge of the bowl-shaped structure. The second diamond part 113 has similar characteristics.

A lateral dimension of the second groove 102 ranges from 5 to 20 µm, and a longitudinal dimension of the second groove may range from 40 to 99 µm. When the first groove 101 has different lateral dimensions at different heights, the foregoing dimensions represent dimensions of an opening of the first groove 101 on the surface of the substrate. When the second groove 102 has different lateral dimensions at different heights, the foregoing dimensions represent dimensions of an opening of the second groove 102 on the surface of the substrate. When the first groove 101 is presented as a circle on the surface of the substrate, a dimension of the first groove 101 is a diameter of the first groove 101. When the first groove 101 is presented as a polygon on the surface of the substrate, the dimension of the first groove 101 is a side length of the first groove 101. The second groove 102 has a similar characteristic.

Specifically, the first grooves 101 may not be in a one-to-one correspondence with the second grooves 102, and a quantity of the second grooves 102 may be less than a quantity of the first grooves 101. In this way, a plurality of first grooves 101 are connected to a same second groove 102, and a shape of the first grooves 101 may be at least one of the conical frustum structure, the square frustum structure, the bowl-shaped structure, the cylindrical structure, and the prism structure, as shown in FIG. 12. As shown in FIG. 12, the second groove 102 may be of an integral structure. The second groove 102 may be longitudinally connected to each of the first grooves 101, or may be longitudinally connected to only a part of the first diamond parts 112, that is, all or a part of the diamond material in the first groove 101 is exposed at the bottom of the second groove 102. There may also be a plurality of second grooves 102, and the second grooves 102 extend in a preset direction parallel to the surface of the substrate. At least one second groove 102 is longitudinally connected to the plurality of first grooves 101, to form a through structure from bottom to top. In other words, diamond materials in the plurality of first grooves 101 are exposed at the bottom of at least one second groove 102.

In this scenario, a large area of the second surface of the substrate may be etched, and most materials of the second surface of the substrate are removed to obtain a cavity structure that is used as the second groove 102. The cavity structure exposes the diamond material in the first groove 101. In this way, after the second groove 102 is filled with the diamond material, the diamond material in the first groove 101 and the diamond material in the second groove 102 are in contact, to form the diamond structure that penetrates the substrate and form a longitudinal heat conduction path. The first diamond part 112 of the diamond structure is in contact with the epitaxial layer on the substrate, and the second diamond part 113 of the diamond structure is exposed outside the substrate. In this way, heat generated inside the device may be conducted toward the outside of the device. A heat sink may be further disposed under the substrate. In this case, the second diamond part 113 of the diamond structure may be in contact with the heat sink, to quickly conduct heat to the heat sink. Therefore, fast heat dissipation of the device is implemented. When the second groove 102 is a large-area cavity structure, an area that is of the diamond structure and that is exposed outside the substrate is large, and an area at which the diamond structure is in contact with the heat sink is also large. Therefore, heat dissipation efficiency is further improved.

It should be noted that there may be the first groove 101 that is not connected to the second groove 102 in the substrate 100, and the first groove 101 may be used as a third groove, or there may be the second groove 102 that is not connected to the first groove 101, and the second groove 102 may be used as a fourth groove. The third groove and the fourth groove do not penetrate the substrate 100, and diamond materials in the third groove and the fourth groove are filled in a part of a depth of the substrate 100. In this case, no heat dissipation channel that penetrates up and down is formed. However, the diamond material in the third groove and the diamond material in the fourth groove can still dissipate heat outward. For example, heat is conducted to other diamond materials through lateral heat conduction, heat is dissipated downward to be directly diffused toward the outside of the device, heat is conducted toward the outside of the device through the substrate 100, or heat is conducted toward the outside of the device through the substrate 100 and other diamond materials.

According to the semiconductor device manufacturing method provided in this embodiment of this application, etching may be performed on the first surface of the substrate to obtain the first groove, the first groove is filled with the diamond material, and the epitaxial layer and the electrode may be sequentially formed on the first surface of the substrate. Then, the second surface of the substrate may be etched to obtain the second groove, where the second groove and the first groove are connected and have different lateral dimensions, and the second groove is filled with the diamond material. In this way, the diamond material in the first groove and the diamond material in the second groove are in contact to form the diamond structure that penetrates the substrate. Due to good thermal conductivity of the diamond part, the diamond structure that penetrates the substrate may form the longitudinal heat conduction channel, so that heat generated by the operating device may be efficiently conducted to a periphery of the device. Therefore, heat dissipation performance of the semiconductor device is improved, and high power performance of the semiconductor device is effectively exerted. In addition, because the first diamond part and the second diamond part have different lateral dimensions, two etching processes may be used, and a depth-to-width ratio of etching is reduced, to help control the structure of the first diamond part and the second diamond part. In addition, heat dissipation performance and lattice matching between the epitaxial layer and the substrate are implemented, so that the epitaxial layer with higher quality and the semiconductor device with high performance can be obtained. At the same time, a manufacturing process of the semiconductor device is not complex, and the substrate is easy to produce on a large scale.

Based on the semiconductor device provided in the foregoing embodiments, an embodiment of this application further provides a semiconductor device manufacturing method. FIG. 13 is a flowchart of another semiconductor device manufacturing method according to an embodiment of this application. In the method, a first diamond part 112 and a second diamond part 113 in a diamond structure may be first formed in a substrate 100, and then a device structure thereon may be formed. Specifically, the method may include the following steps.

S201: Provide the substrate 100.

In this embodiment of this application, the substrate 100 is a component that provides support for the device, has certain thermal conductivity, and can dissipate heat generated by the operating device to the outside. The substrate 100 may be a semi-insulating semiconductor material. Specifically, a material of the substrate 100 may be one or more of silicon, silicon carbide, aluminum nitride, and sapphire. The following describes an example in which the material of the substrate 100 is silicon carbide, to be specific, 4H-SiC single crystal. Thermal conductivity of a 4H-SiC single substrate material generally ranges from 280 to 370 W/mk. This limits high power performance of the semiconductor device.

S202: Etch a first surface of the substrate 100 to obtain a first groove 101, and fill the first groove 101 with a diamond material; and etch a second surface of the substrate 100 to obtain a second groove 102, where the second groove 102 is connected to the first groove 101, and the first groove 101 and the second groove 102 have different lateral dimensions, and fill the second groove 102 with a diamond material.

In this embodiment of this application, the first surface of the substrate 100 may be etched to obtain the first groove 101, and the first groove 101 is filled with the diamond material. The diamond material filled in the first groove 101 may be used as the first diamond part 112 in the foregoing embodiment. The substrate 100 may be etched through dry anisotropic etching, such as plasma etching. A lateral dimension of the first groove 101 obtained through etching is 1 to 10 µm, an etching depth is 1 to 10 µm, a spacing between different first grooves 101 ranges from 1 to 10 µm, and the first grooves 101 may be arranged in a periodic array.

A shape of the first groove 101 may be controlled by controlling an etching parameter of the substrate 100. The shape of the first groove 101 may be at least one of a conical frustum structure, a square frustum structure, a bowl-shaped structure, a cylindrical structure, and a prism structure. One end with a larger dimension of the conical frustum structure, the square frustum structure, and the bowl-shaped structure faces a surface of the substrate. In an etching process, an etching rate may be slowed down, to reduce damage caused by etching gas to a side wall of the first groove 101. In this way, the first groove 101 with a structure that is larger on an upper part and small on a lower part is formed.

After the first groove 101 is formed through etching, the first groove 101 may be filled with the diamond material, and the diamond material is a monocrystalline diamond or a polycrystalline diamond. Specifically, the diamond material may be grown on the substrate 100 on which the first groove 101 is formed. After a period of growth, a high-quality polycrystalline diamond layer 111 with a thickness of 1 to 50 µm may be generated on the substrate 100. Then, a part of the diamond layer 111 is removed through grinding and polishing to expose the surface of the substrate 100. In this way, the diamond material is filled in the first groove 101, and a dimension of the diamond material is consistent with or approximate to a dimension of the first groove 101. The diamond material may be grown by using an MPCVD method, and a temperature at which the diamond material is grown may range from 800 to 1200 °C, and a pressure may range from 1 to 15 kPa. The MPCVD method has advantages such as stable plasma discharge and less pollution, so that a diamond material with high quality can be grown.

In this embodiment of this application, the second surface of the substrate 100 may be further etched to obtain the second groove 102, and the second groove 102 is filled with the diamond material. The first surface and the second surface are two opposite surfaces. The diamond material in the second groove 102 may be used as the second diamond part 113 in the foregoing embodiments. The first groove 101 and the second groove 102 are connected, and the diamond material in the first groove 101 and the diamond material in the second groove 102 are in contact to form a diamond structure that penetrates the substrate 100. Because the first groove 101 and the second groove 102 have different lateral dimensions, diamond structures that are separately formed by the first groove 101 and the second groove 102, that is, the first diamond part 112 and the second diamond part 113, have different lateral dimensions. Due to good thermal conductivity of a diamond, the diamond structure that longitudinally penetrates the substrate 100 may form a longitudinal heat dissipation channel. This greatly improves heat dissipation efficiency of the device. Before the second surface of the substrate 100 is etched, the substrate 100 may be further thinned from the second surface of the substrate 100, so that a thickness of the substrate 100 ranges from 50 to 100 µm, and a sum of longitudinal dimensions of the first diamond part 112 and the second diamond part 113 is the same as a thickness of the substrate 100.

It should be noted that an etching sequence of the first groove 101 and the second groove 102 may be arbitrary. If the first groove 101 is etched before the second groove 102, the first groove 101 needs to be filled with the diamond material before the second groove 102 is etched, and the diamond material in the first groove 101 is exposed at the bottom of the second groove 102. If the second groove 102 is etched before the first groove 101, the second groove 102 needs to be filled with the diamond material before the first groove 101 is etched, and the diamond material in the second groove 102 is exposed at a bottom of the first groove 101.

Specifically, the first groove 101 may be in a one-to-one correspondence with the second groove 102, and one first groove 101 may be connected to one second groove 102 to form a through hole that penetrates the substrate 100. Shapes of the first groove 101 and the second groove 102 may be at least one of a conical frustum structure, a square frustum structure, a bowl-shaped structure, a cylindrical structure, and a prism structure. The shapes of the first groove 101 and the second groove 102 may be the same or different. When the first diamond part 112 is of the conical frustum structure, the square frustum structure, or the bowl-shaped structure, one end with a larger lateral dimension is generally located in a direction of the surface of the substrate 100. When the second diamond part 113 is of the conical frustum structure, the square frustum structure, or the bowl-shaped structure, one end with a larger lateral dimension is generally located in the direction of the surface of the substrate 100. When the first groove 101 is of the conical frustum structure, the square frustum structure, or the bowl-shaped structure, an included angle between a side wall of the first groove 101 and the surface of the substrate is 10 to 80 degrees, and specifically, may be 30 to 60 degrees. An included angle between a side wall of the bowl-shaped structure and the surface of the substrate may be defined as an included angle between the surface of the substrate and a line connecting a center point of a bottom of the bowl-shaped structure and an upper edge of the bowl-shaped structure. The second diamond part 113 has similar characteristics.

A lateral dimension of the second groove 102 ranges from 5 to 20 µm, and a longitudinal dimension of the second groove may range from 40 to 99 µm. When the first groove 101 has different lateral dimensions at different heights, the foregoing dimensions represent dimensions of an opening of the first groove 101 on the surface of the substrate. When the second groove 102 has different lateral dimensions at different heights, the foregoing dimensions represent dimensions of an opening of the second groove 102 on the surface of the substrate. When the first groove 101 is presented as a circle on the surface of the substrate, a dimension of the first groove 101 is a diameter of the first groove 101. When the first groove 101 is presented as a polygon on the surface of the substrate, the dimension of the first groove 101 is a side length of the first groove 101. The second groove 102 has a similar characteristic.

Specifically, the first grooves 101 may not be in a one-to-one correspondence with the second grooves 102, and a quantity of the second grooves 102 may be less than a quantity of the first grooves 101. In this way, a plurality of first grooves 101 are connected to a same second groove 102, and a shape of the first grooves 101 may be at least one of the conical frustum structure, the square frustum structure, the bowl-shaped structure, the cylindrical structure, and the prism structure.

The second groove 102 may be of an integral structure, and the second groove 102 may be longitudinally connected to all of the first grooves 101, or may be longitudinally connected to only a part of the first grooves 101. Specifically, if the second groove 102 is formed after the first groove 101, all or a part of the diamond material in the first groove 101 may be exposed at the bottom of the second groove 102. If the second groove 102 is formed before the first groove 101, the diamond material in the second groove 102 is exposed at the bottoms of the plurality of first grooves 101.

There may also be a plurality of second grooves 102, and the second grooves 102 extend in a preset direction parallel to the surface of the substrate. At least one second groove 102 is longitudinally connected to the plurality of first grooves 101, to form a through structure from bottom to top. Specifically, if the second groove 102 is formed before the first groove 101, diamond materials in the plurality of first grooves 101 are exposed at the bottom of at least one second groove 102. If the second groove 102 is formed after the first groove 101, the diamond material in the same second groove 102 is exposed at the bottoms of the plurality of first grooves 101.

In this scenario, a large area of the second surface of the substrate 100 may be etched, most materials of the second surface of the substrate 100 are removed to obtain a cavity structure that is used as the second groove 102, and the first groove 101 is connected to the second groove 102. In this way, after the first groove 101 and the second groove 102 are filled with the diamond material, the diamond material in the first groove 101 and the diamond material in the second groove 102 are in contact to form the diamond structure that penetrates the substrate 100 and form a longitudinal heat conduction path. The first diamond part 112 of the diamond structure is in contact with the epitaxial layer on the substrate 100, and the second diamond part 113 of the diamond structure is exposed outside the substrate 100. In this way, heat generated inside the device may be conducted toward the outside of the device. A heat sink may be further disposed under the substrate 100. In this case, the second diamond part 113 of the diamond structure may be in contact with the heat sink, to quickly conduct heat to the heat sink. Therefore, fast heat dissipation of the device is implemented. When the second groove 102 is a large-area cavity structure, an area that is of the diamond structure and that is exposed outside the substrate 100 is large, and an area at which the diamond structure is in contact with the heat sink is also large. Therefore, heat dissipation efficiency is further improved.

It should be noted that there may be the first groove 101 that is not connected to the second groove 102 in the substrate 100, and the first groove 101 may be used as a third groove, or there may be the second groove 102 that is not connected to the first groove 101, and the second groove 102 may be used as a fourth groove. The third groove and the fourth groove do not penetrate the substrate 100, and diamond materials in the third groove and the fourth groove are filled in a part of a depth of the substrate 100. In this case, no heat dissipation channel that penetrates up and down is formed. However, the diamond material in the third groove and the diamond material in the fourth groove can still dissipate heat outward. For example, heat is conducted to other diamond materials through lateral heat conduction, heat is dissipated downward to be directly diffused toward the outside of the device, heat is conducted toward the outside of the device through the substrate 100, or heat is conducted toward the outside of the device through the substrate 100 and other diamond materials.

S203: Sequentially form an epitaxial layer 200 and electrodes 401, 402, and 403 on the substrate 100.

The epitaxial layer 200 may be formed on the substrate 100. When the semiconductor device is a GaN-based HEMT device, the epitaxial layer 200 may include a buffer layer and a barrier layer. The buffer layer and the barrier layer may form a heterostructure, to generate two-dimensional electron gas, and a formed semiconductor device may work by using the two-dimensional electron gas generated by the heterostructure. The buffer layer may be a gallium nitride layer, and a material of the barrier layer may be at least one of AlGaN, InAlN, AlN, and ScAlN. A thickness of the buffer layer may range from 0.1 to 2 µm, and a thickness of the barrier layer may range from 5 to 20 nm.

Specifically, the buffer layer may be formed on the first surface of the substrate 100, and then the barrier layer may be formed on the buffer layer. The gallium nitride layer may be formed in an MOCVD manner. Because a lattice mismatch between the diamond material and the gallium nitride is severe, the gallium nitride grows quickly on the silicon carbide, and grows slowly or even cannot grow on the diamond material. In this way, lateral growth of gallium nitride on silicon carbide is strengthened, and dislocations are combined, to obtain the gallium nitride layer with higher quality. When the diamond material formed in the first groove 101 is of the conical frustum structure, the square frustum structure, or the bowl-shaped structure, it is more conducive for growth of gallium nitride on the substrate 100. Therefore, the gallium nitride layer with higher quality is obtained. The gallium nitride layer may include a low-temperature gallium nitride layer and a high-temperature gallium nitride layer, and the low-temperature gallium nitride layer serves as the buffer layer between the high-temperature gallium nitride layer and the substrate 100, to improve epitaxial quality of the high-temperature gallium nitride layer. The barrier layer may also be formed in the MOCVD manner.

The electrodes 401, 402, and 403 may be formed on the epitaxial layer 200. The electrodes 401, 402, and 403 may include the source electrode 401, the drain electrode 403, and the gate electrode 402. The gate electrode 402 may be located between the source electrode 401 and the drain electrode 403. A material of the electrodes 401, 402, and 403 may be a metal material, for example, may be at least one of Au, Ti, Al, Ni, and Ta. In a possible implementation, the material of the electrodes 401, 402, and 403 may be Au, Ti/Al/Ni/Au stack, or Ta/Al/Ta stack. After the electrodes 401, 402, and 403 are formed, a dielectric layer may also be formed to cover the electrodes, to protect the electrodes 401, 402, and 403.

According to the semiconductor device manufacturing method provided in this embodiment of this application, etching may be performed on the first surface of the substrate to obtain the first groove, the first groove is filled with the diamond material, and the second surface of the substrate is etched to obtain the second groove. The second groove is connected to the first groove, and the first groove and the second groove have different lateral dimensions. Then, the second groove is filled with the diamond material, and the epitaxial layer and the electrode are sequentially formed on the first surface of the substrate. In this way, the diamond material in the first groove and the diamond material in the second groove are in contact to form the diamond structure that penetrates the substrate. Due to good thermal conductivity of the diamond part, the diamond structure that penetrates the substrate may form the longitudinal heat conduction channel, so that heat generated by the operating device may be efficiently conducted to a periphery of the device. Therefore, heat dissipation performance of the semiconductor device is improved, and high power performance of the semiconductor device is effectively exerted. In addition, because the first diamond part and the second diamond part have different lateral dimensions, two etching processes may be used, and a depth-to-width ratio of etching is reduced, to help control the structure of the first diamond part and the second diamond part. In addition, heat dissipation performance and lattice matching between the epitaxial layer and the substrate are implemented, so that the epitaxial layer with higher quality and the semiconductor device with high performance can be obtained. At the same time, a manufacturing process of the semiconductor device is not complex, and the substrate is easy to produce on a large scale.

Embodiments in this specification are all described in a progressive manner. For same or similar parts in embodiments, refer to these embodiments, and each embodiment focuses on a difference from other embodiments. In particular, the method embodiment is basically similar to a structural embodiment, and therefore is described briefly. For related parts, refer to some descriptions of the structural embodiment.

The foregoing provides specific implementations of this application. It should be understood that the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A semiconductor device, comprising:
a substrate, wherein the substrate has a diamond structure that longitudinally penetrates the substrate, the diamond structure is longitudinally divided into a first diamond part and a second diamond part below the first diamond part, and the first diamond part and the second diamond part have different lateral dimensions; and
an epitaxial layer and an electrode that are sequentially located on the substrate.

2. The device according to claim 1, wherein there are a plurality of first diamond parts and a plurality of second diamond parts, the plurality of first diamond parts one-to-one correspond to the plurality of second diamond parts, and the plurality of first diamond parts are of at least one of a conical frustum structure, a square frustum structure, a bowl-shaped structure, a cylindrical structure, and a prism structure.

3. The device according to claim 1, wherein a quantity of second diamond parts is less than a quantity of first diamond parts, a plurality of first diamond parts are connected to a same second diamond part, and the first diamond parts are of at least one of a conical frustum structure, a square frustum structure, a bowl-shaped structure, a cylindrical structure, and a prism structure.

4. The device according to claim 3, wherein there is one second diamond part, and the second diamond part is longitudinally connected to all or a part of the first diamond parts.

5. The device according to claim 3, wherein there are a plurality of second diamond parts, the second diamond parts extend in a preset direction parallel to a surface of the substrate, and at least one second diamond part is longitudinally connected to the plurality of first diamond parts.

6. The device according to any one of claims 1 to 5, wherein a lateral dimension of the first diamond part ranges from 1 to 10 µm, a longitudinal dimension of the first diamond part ranges from 1 to 10 µm, a spacing between different first diamond parts ranges from 1 to 10 µm, and a thickness of the substrate ranges from 50 to 100 µm.

7. The device according to any one of claims 1 to 6, wherein a material of the substrate is one or more of silicon, silicon carbide, aluminum nitride, and sapphire.

8. The device according to any one of claims 1 to 7, wherein the diamond part is a monocrystalline diamond or a polycrystalline diamond.

9. The device according to any one of claims 1 to 8, wherein the epitaxial layer comprises a buffer layer and a barrier layer, the buffer layer is a gallium nitride layer, and a material of the barrier layer is one or more of AlGaN, InAlN, AlN, and ScAlN.

10. The device according to claim 9, wherein a thickness of the gallium nitride layer ranges from 0.1 to 2 µm, and a thickness of the barrier layer ranges from 5 to 20 nm.

11. The device according to any one of claims 1 to 10, wherein the electrode comprises a source electrode, a drain electrode, and a gate electrode, and a material of the electrode is at least one of Au, Ti, Al, Ni, and Ta.

12. A method for manufacturing a semiconductor device, comprising:
providing a substrate;
etching a first surface of the substrate to obtain a first groove;
filling the first groove with a diamond material;
sequentially forming an epitaxial layer and an electrode on the first surface of the substrate;
etching a second surface of the substrate to obtain a second groove, wherein the second groove and the first groove are connected and have different lateral dimensions, and the first surface and the second surface are two opposite surfaces; and
filling the second groove with a diamond material.

13. The method according to claim 12, wherein there are a plurality of first grooves and a plurality of second grooves, the plurality of first grooves one-to-one correspond to the plurality of second grooves, and a shape of diamond materials in the first groove and the second groove is at least one of a conical frustum structure, a square frustum structure, a bowl-shaped structure, a cylindrical structure, and a prism structure.

14. The method according to claim 12, wherein a quantity of second grooves is less than a quantity of first grooves, a plurality of first grooves are connected to a same second groove, and a shape of the first grooves is one of a conical frustum structure, a square frustum structure, a bowl-shaped structure, a cylindrical structure, and a prism structure.

15. The method according to claim 14, wherein there is one second groove, and all or a part of diamond materials in the first grooves are exposed at the bottom of the second groove.

16. The method according to claim 14, wherein the second grooves are a plurality of grooves that extend in a preset direction parallel to a surface of the substrate, and diamond materials in the plurality of first grooves are exposed at the bottom of at least one second groove.

17. The method according to any one of claims 12 to 16, wherein before the etching a second surface of the substrate to obtain a second groove, the method further comprises:
thinning the substrate from the second surface of the substrate.

18. A method for manufacturing a semiconductor device, comprising:
providing a substrate;
etching a first surface of the substrate to obtain a first groove, and filling the first groove with a diamond material; and etching a second surface of the substrate to obtain a second groove, and filling the second groove with the diamond material, wherein the second groove and the first groove are connected and have different lateral dimensions, and the first surface and the second surface are two opposite surfaces; and
sequentially forming an epitaxial layer and an electrode on the first surface of the substrate.

19. The method according to claim 18, wherein there are a plurality of first grooves and a plurality of second grooves, the plurality of first grooves one-to-one correspond to the plurality of second grooves, and a shape of diamond materials in the first groove and the second groove is at least one of a conical frustum structure, a square frustum structure, a bowl-shaped structure, a cylindrical structure, and a prism structure.

20. The method according to claim 18, wherein a quantity of second grooves is less than a quantity of first grooves, a plurality of first grooves are connected to a same second groove, and the first grooves are of at least one of a conical frustum structure, a square frustum structure, a bowl-shaped structure, a cylindrical structure, and a prism structure.

21. The method according to claim 20, wherein there is one second groove; if the second groove is formed after the first groove, all or a part of diamond materials in the first grooves are exposed at the bottom of the second groove; and if the second groove is formed before the first groove, a diamond material in the second groove is exposed at the bottoms of the plurality of first grooves.

22. The method according to claim 20, wherein the second grooves are a plurality of grooves that extend in a preset direction parallel to a surface of the substrate; if the second groove is formed after the first groove, diamond materials in the plurality of first grooves are exposed at the bottom of at least one second groove; and if the second groove is formed before the first groove, a diamond material in the same second groove is exposed at the bottoms of the plurality of first grooves.

23. The method according to any one of claims 18 to 22, wherein before the etching a second surface of the substrate to obtain a second groove, the method further comprises:
thinning the substrate from the second surface of the substrate.

24. A power amplifier chip, comprising the semiconductor device according to any one of claims 1 to 11.
